# EUROPÄISCHE PATENTANMELDUNG

(11) **EP 1 123 989 A2**
(43) Veröffentlichungstag der Anmeldung: **16.08.2001**
(21) Anmeldenummer: 01101726.6
(22) Anmeldetag: 25.01.2001
(51) Int. Cl.: C23C 14/06, C23C 14/02

(54) **Verfahren zur Herstellung von Beschichtungen sowie Gegenstand**

(30) Priorität: 09.02.2000 DE 10005614
(71) Anmelder: HAUZER TECHNO COATING EUROPE BV, 5902 RB Venlo (NL)
(72) Erfinder: Strondl, Christian G. C., 5913 CM Venlo (NL); Hurkmans, Antonius P.A., Taylorsville, NC 28681 (US); Van der Kolk, Gerrit Jan, 6026 RG Maarheeze (NL)
(74) Vertreter: Manitz, Finsterwald & Partner

(57) **Zusammenfassung**

Die Erfindung betrifft ein Verfahren zur Herstellung von Beschichtungen mit niedriger Reibungszahl auf Gegenständen wie mechanischen Bauteilen und Werkzeugen, wobei man auf dem Gegenstand mittels eines PVD-Verfahrens eine Schichtfolge von Kohlenstoff und einem Karbid mindestens eines Elements in Form eines Metalls und/oder Silizium und/oder Bor ablagert. Beansprucht werden auch Gegenstände, die eine solche Schichtfolge aufweisen. Die Beschichtung hat eine niedrige Reibungszahl, ist abriebfest und hat eine relativ hohe Härte wie auch eine relativ hohe Elastizität.

## Beschreibung

Die vorliegende Erfindung betrifft ein Verfahren zur Herstellung Beschichtungen mit niedriger Reibungszahl auf Gegenständen wie mechanischen Bauteilen und Werkzeugen sowie Gegenstände, die eine entsprechende Beschichtung aufweisen.

Es wurden bereits verschiedene Vorschläge zur Erzielung von mittels PVD-Verfahren erzeugten Oberflächen, die eine relativ niedrige Reibungszahl aufweisen, gemacht.

Beispielsweise offenbart die internationale Patentanmeldung mit der Veröffentlichungsnummer WO97/49840 die Erzeugung einer superharten Oberfläche auf metallischen, keramischen oder organischen Grundwerkstoffen.

Zu diesem Zweck wird zunächst eine karbidische Zwischenschicht, z.B. aus TiC auf dem Grundwerkstoff des Gegenstandes abgelagert. Danach wird eine relativ dicke, im wesentlichen aus reinem, sp₂ und sp₃-hybridisiertem Kohlenstoff bestehenden Schicht auf die Zwischenschicht abgelagert, wobei diese Schicht eine Gradientenschicht ist, bei der der Anteil des sp₃-hybridisiertem Kohlenstoffs in Richtung auf die freie Oberfläche ansteigt. Diese Gradientenschicht ist mit einer Dicke zwischen 0,5 und 5 µm angegeben. Der steigende Anteil von sp₃-Bindungen wird durch Erhöhung der Bias-Spannung bis auf ca. 300 V erzeugt.

Genaue Angaben zu den prozentualen Anteilen von sp₃-Bindungen sind in der Schrift nicht enthalten. Es wird lediglich zum Ausdruck gebracht, daß an der Grenzfläche zur Zwischenschicht ein überwiegender Anteil an sp₂-hybridisierten Bindungen vorhanden ist, um die Haftung zur Zwischenschicht (oder zum Substrat, wenn die Zwischenschicht weggelassen wird) zu vermitteln, und daß an der freien Oberfläche die sp₃-Bindungen überwiegen. Somit besteht die freie Oberfläche der Schicht nach den dort zu lesenden Aussagen aus diamantartigem, und damit entsprechend hartem Kohlenstoff.

Die internationale Anmeldung mit der Veröffentlichungsnummer WO99/27893 beschreibt dagegen einen Gegenstand mit einer Kohlenstoff enthaltenden Beschichtung, die im wesentlichen aus einer Reihenfolge von Kohlenstoff und Metall enthaltenden Schichten besteht, bei der die Kohlenstoff-Kohlenstoff-Bindung innerhalb jeder Kohlenstoff-Schicht vorwiegend in Form der graphitischen sp₂-Bindungen vorliegt. Nach Aussage dieser Schrift weisen die Kohlenstoff und Metall enthaltenden Zwischenschichten eine Periode von mindestens 3 nm auf. Bei den konkreten Beispielen wird auch eine ein Metall enthaltende Unterschicht verwendet, die aus Titan oder Chrom besteht und eine Dicke im Bereich zwischen 50 nm und 200 nm aufweist. Bei diesem Vorschlag bestehen also die Kohlenstoffschichten vorwiegend aus graphitischem Kohlenstoff mit sp₂-Bindungen.

Aufgabe der vorliegenden Erfindung ist es, ein Verfahren vorzusehen, mit dem eine Beschichtung mit niedriger Reibungszahl sowie niedriger Abnutzung, jedoch relativ hoher Härte als auch relativ hoher Elastizität auf beinahe beliebigen Gegenständen erzeugt werden kann, sowie Gegenstände mit einer solchen Beschichtung vorzusehen.

Zur Lösung dieser Aufgabe wird erfindungsgemäß vorgesehen, daß man auf den Gegenstand mittels eines PVD-Verfahrens eine Schichtfolge von abwechselnden Kohlenstoff- und Karbidschichten aufbaut, wobei die Karbidschichten aus einem Karbid mindestens eines Elementes in Form eines Metalls und/oder Silizium und/oder Bor gebildet sind und der Kohlenstoff durch Zerstäubung eines Targets aus Graphit erzeugt wird, wobei das Verfahren so durchgeführt wird, daß die Schichtdicke jeder Kohlenstoff-schicht der Schichtfolge im Bereich zwischen etwa 1 nm und etwa 20 nm, vorzugsweise zwischen 2 und 4 nm liegt, wobei die oberste Schicht der Schichtfolge vorzugsweise aus Kohlenstoff besteht und mit Vorteil etwas dicker als die anderen Schichten sein darf, beispielsweise 500 nm, wobei die Schichtdicke der Karbidschichten im Bereich zwischen 1 und 3 nm, vorzugsweise bei etwa 2 nm liegt und wobei der Kohlenstoff der Kohlenstoffschicht vorwiegend sp₃-Bindungen aufweist.

Der Gehalt von sp3-Bindungen wird von Plasma-Parametern, wie Vorspannung und Plasmadichte beeinflußt. Die Plasmadichte wird teilweise durch die magnetische Feldstärke kontrolliert, die in der Umgebung von den zu beschichtenden Teilen relativ hoch zu wählen ist. Dies kann über die elektromagnetische Spule erfolgen, die für das Feld sorgt, das für den Betrieb der entsprechenden Kathode als unbalanciertes Magnetron zuständig ist. Das Verhältnis sp3/sp2-Bindungen kann zum Teil durch den Wasserstoffgehalt im Schichtsystem beeinflußt werden.

Durch die Erfindung werden im Gegensatz zur WO99/27893 Kohlenstoffschichten erzeugt, die vorwiegend aus sp₃-Bindungen bestehen. Diese Schichten sind jeweils relativ dünn ausgebildet, üblicherweise unter 3 nm und daher in einer Dicke noch kleiner als die in der WO99/27893 angegebene kleinste Dicke. Auch die Karbid-Zwischenschichten sind relativ dünn. Obwohl, wenn man nach der WO97/49840 urteilen würde, die vorwiegend aus sp₃-Bindungen bestehenden Kohlenstoffschichten eine schlechte Haftung zu den darunter liegenden Metall-Karbid-Schichten aufweisen müßten, wurde erfindungsgemäß und überraschenderweise festgestellt, daß auch bei vorwiegend sp₃-Bindungen eine gute Haftung erreicht wird, man aber außerdem den Vorteil der höheren Härte einer aus sp3-Bindungen bestehenden Kohlenstoffschicht genießt, und zwar - ebenfalls überraschenderweise - mit einer relative hohen Elastizität, so daß Rißbildung und Abplatzen der Beschichtung weitestgehend reduziert wird und die Beschichtung Oberflächenunebenheiten bei den Reibungspartnern tolerieren kann, ebenfalls ohne mechanischen Schaden zu erleiden. Die Beschichtung ist ebenfalls gegen Stoßbelastungen widerstandsfähig.

Durch die relativ dünnen Schichten und die Herstellung in einer üblichen PVD-Anlage, in der die zu beschichtenden Gegenstände auf einem Substratträger abwechselnd durch die Dampfströme von den einzelnen Targets hindurchbewegt werden, wird ein gradueller Übergang von der einen Schicht zur nächsten geschaffen, was ebenfalls der mechanischen Verankerung der Schichten zugute kommt.

Insbesondere soll das Element aus der Gruppe W, Ti, V, Cr, Zr, Nb, Mo, Hf, Ta und B und Si ausgewählt werden. Hiermit kann man auf die verschiedensten Gegenstände eine hochwirksame Beschichtung mit relativ niedriger Reibungszahl und niedrigen Abnutzungsraten sowie hoher Härte und hoher Elastizität erzeugen. Insbesondere W eignet sich für die Herstellung der Karbidschichten

Die vorliegende Erfindung umfaßt auch einen Gegenstand mit den Merkmalen des Anspruchs 16.

Als Beispiel für zu beschichtende Gegenstände kann man folgende Bauteile und Werkzeuge nennen:
- Gleitlager, Rollenlager,
- verschiedene Motorenteile wie Nockenstößel, Nockenwellen, Kipphebel,
- Teile von Benzin- und Dieseleinspritzsysteme, wie Kolben, Nadel, Einspritzdüsen- und scheiben,
- Zahnräder, um Grubchenbildung, Anfreßungen, Ermüdungsrißen und adhäsiven Verschleiß zu vermindern,
- Teile von Hydraulikanlagen, z.B. Ventilschieber,
- Formen, z.B. Spritzgußformen und Kunststoffformen.

Im allgemeinen kann die erfindungsgemäße Beschichtung auf alle Oberflächen von mechanischen Bauteilen und Gegenständen aufgebracht werden, die eine niedrige Reibung aufweisen und eine abnutzungsresistente Oberflächenbeschichtung mit Trockenschmierungseigenschaften aufweisen sollen, z.B. können CrN + Kohlenstoff / Metallkarbidbeschichtungen auf Formen (Kunststofformen) aufgebracht werden, um die Abnutzung herabzusetzen und antihaft-Eigenschaften zu erhöhen, was gleichbedeutend ist mit weniger Reibung und Einsparen von Gleitmitteln. Die erfindungsgemäße Beschichtung kann auch als Gleitbeschichtung auf TiAlN-, TiN- oder TiCN-beschichteten Teilen und Werkzeugen und als Oberbeschichtung auf Bohrer für Tieflochbohrvorgängen aufgebracht werden.

Das Problem beim Bohren von tiefen Löchern ist nämlich die mangelnde Kühlmittelzufuhr zur Bohrspitze und der lange Weg zum Abführen der Späne, die durch höhere Reibung zur erhöhten Schneidtemperatur in der Hohlkehle des Bohrers führt, welche wiederum zu frühem Schneidversagen des Bohrers führt. Hier wird die erfindungsgemäße Beschichtung aus Kohlenstoff / Metallkarbid als Trockenschmiermittel verwendet, um Schneidtemperaturen herabzusetzen und die Spanabfuhr durch reduzierte Reibung in der Hohlkehle zu verbessern.

Die Gesamtdicke der Schichtfolge liegt üblicherweise im Bereich zwischen etwa 0,1 µ und 20 µm, vorzugsweise zwischen 1 µm und 5 µm. Für manche Anwendungen, beispielsweise für die Beschichtung von Pleuel von Verbrennungsmotoren ist es notwendig, dickere Beschichtungen vorzunehmen, d.h. Beschichtungen mit einer Gesamtdicke über 10 µm. Aus diesen Angaben ist ersichtlich, daß man erfindungsgemäß eine Schichtfolge mit etwa 30 bis 3000 Einzelschichten bevorzugt. Diese Vielzahl von Schichten lassen sich besonders günstig herstellen, wenn man mit einer Vorrichtung mit einer Behandlungskammer, in der die zur Herstellung der Schichtfolge erforderlichen Kohlenstoff- und Metallkarbid-Targets untergebracht sind, arbeitet und für eine Bewegung der Gegenstände sorgt, so daß die Gegenstände abwechselnd den Dampffluß von den einzelnen Targets durchlaufen. Dies ist an sich im Zusammenhang mit PVD-Verfahren bekannt. Es können nicht nur einfache Drehungen um eine Achse, sondern auch komplexe Drehungen um zwei, drei oder mehr Achsen durchgeführt werden, um eine möglichst gleichmäßige Beschichtung aller Oberflächen der Gegenstände oder eine gezielte Beschichtung einer beliebigen Oberfläche zu erreichen.

Besonders günstig ist es, wenn das Verfahren als nicht reaktives Kathoden-Zerstäubungs-Verfahren durchgeführt wird, insbesondere unter Anwendung eines unbalanzierten Magnetrons. Die hierfür vorgesehene Vorrichtung kann beispielsweise entsprechend dem europäischen Patent 0 439 561 oder entsprechend der europäischen Patentanmeldung 99 113 848.8 ausgelegt werden. Die magnetische Feldstärke ist relativ hoch gewählt, so daß die Feldstärke im Produktraum einen Wert von typisch 300 Gauss hat. Die Feldstärke kann während der Beschichtung geändert werden, z.B. durch die Anwendung von elektromagnetischen Spulen, die die kathodischen Quellen umgeben. Durch den Einbau von Wasserstoff in die Beschichtung kann das Verhältnis der Anteile an sp3-Bindungen im Vergleich zu sp2-Bindungen positiv beeinflußt werden.

Besonders günstig ist es auch, wenn das nicht reaktive Kathoden-Zerstäubungs-Verfahren in einer Inertgasatmosphäre, insbesondere einer Argonatmosphäre durchgeführt wird. Der nicht reaktiven Atmosphäre des PVD-Verfahrens kann außerdem Wasserstoff oder ein Kohlenwasserstoff CₓH_{y} (x und y sind Integerzahlen), vorzugsweise in Form von C₂H₂, zugeführt werden, wodurch Wasserstoff in die Beschichtung aufgenommen und eingebaut wird, da dies zur weiteren Herabsetzung der Reibungszahl beiträgt.

Um die Haftung der erfindungsgemäßen Kohlenstoff-/Karbidbeschichtung auf den Gegenstand zu verbessern, ist eine Reinigung der Oberfläche durch Ionenätzen zu Anfang des Verfahrens zu empfehlen sowie die Ablagerung einer Cr-Schicht oder Ti-Schicht als Übergangsschicht zwischen dem Gegenstand und der erfindungsgemäßen Kohlenstoffschicht-/Karbidbeschichtung. Diese Übergangsschicht z.B. aus Cr hat z.B. eine Dicke im Bereich von etwa 1 nm bis etwa 1 µm, insbesondere 0,1 µm bis 0,5 µm und wird vorzugsweise so abgelagert, daß der Anteil Cr in der Übergangsschicht stufenweise oder kontinuierlich in Richtung zur freien Oberfläche des Gegenstands herabgesetzt wird.

Besonders bevorzugte Ausführungsformen des erfindungsgemäßen Verfahrens sowie Gegenstände mit einer erfindungsgemäßen Beschichtung lassen sich den weiteren Patentansprüchen entnehmen.

Die Erfindung wird nachfolgend näher erläutert anhand eines Ausführungsbeispiels unter Bezugnahme auf die Zeichnung, die zeigt:
- Fig. 1: ein Beispiel für den Schichtaufbau einer erfindungsgemäßen Kohlenstoff-/Karbidbeschichtung mit niedriger Reibungszahl auf einem Substrat,
- Fig. 2: eine für die Durchführung des erfindungsgemäßen Verfahrens besonders geeignete Beschichtungsanlage in schematischer Darstellung, und
- Fig. 3: eine Tabelle, welche die Betriebsbedingungen gemäß eines bevorzugten Beispiels angeben.

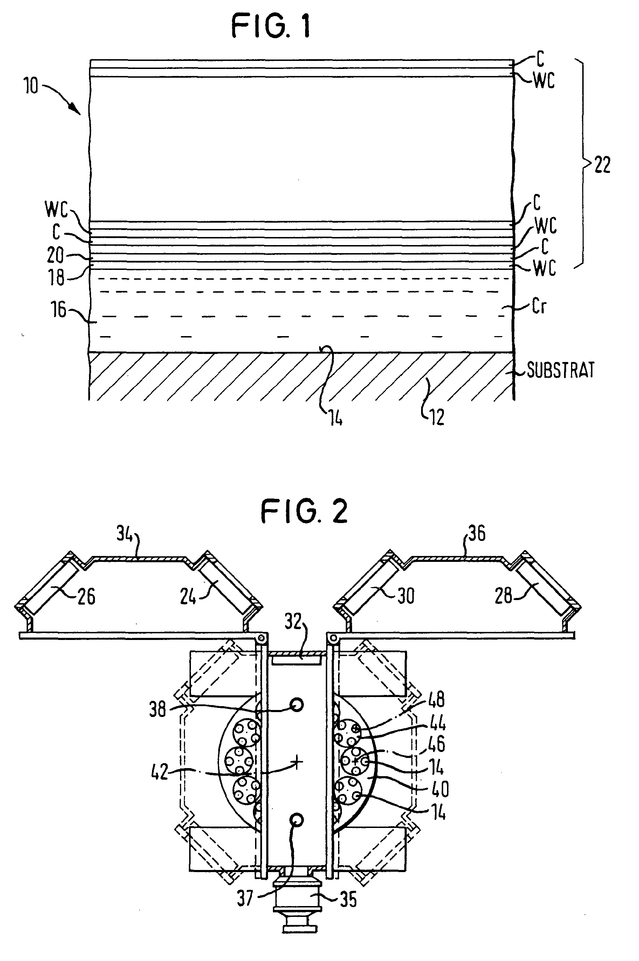

Fig. 1 zeigt in schematischer Weise ein Beispiel einer erfindungsgemäßen, mehrlagigen Kohlenstoff- und Karbidschicht aus abwechselnden Schichtfolgen 10 zur Schaffung einer Beschichtung auf einem Substrat 12. Die Beschichtung in Form der Schichtfolge 10, die auf einem beliebigem Substrat 12 aufgebracht werden kann, sorgt für eine niedrige Trockenreibungszahl von etwa 0,2 und in den bisher günstigsten Fällen von nur etwas mehr als 0,1, wobei die Beschichtung nicht nur eine niedrige Reibungszahl, sondern auch eine geringe Abnutzung, eine relativ hohe Härte (Vickers Mikrohärte 0,025 größer als 1000, typisch 1500 bis 2200) und auch eine hohe Elastizität (Emodulus geringer als 300 Gpa) aufweist.

In diesem Beispiel befindet sich auf der mittels eines Ionenätzverfahrens unter Anwendung von Argonionen geätzten Oberfläche 14 des Substrats eine Übergangsschicht 16 aus Cr mit einer Dicke im Bereich von etwa 1 nm bis ca. 2 µm, üblicherweise 0,1 µm bis 0,5 µm, und in diesem Beispiel ca. 0,3 µm.

Auf der dem Substrat 12 abgewandten Oberfläche der Übergangsschicht 16 befindet sich eine Schicht aus WC mit einer Dicke im Bereich zwischen etwa 1 nm und 3 nm, vorzugsweise etwa 2 nm, wie in diesem Beispiel realisiert.

Dieser WC-Schicht 18 folgt eine Kohlenstoffschicht 20 und danach abwechselnd eine Vielzahl von weiteren WC- und C-Schichten 22, wobei in diesem Beispiel ca. 140 einzelne Schichten vorgesehen sind und die oberste Schicht eine Kohlenstoff-Schicht ist. Die Gesamtzahl der abwechselnden C-/TiC-Schichten ist nicht kritisch. Sie kann ohne weiteres auch weniger als 30 und mehr als 3000 betragen.

In dem gezeigten Beispiel nach Fig. list die oberste Schicht eine Kohlenstoff-Schicht. Die Schichtdicken der Kohlenstoffschichten sind im Bereich zwischen 1 nm und 20 nm vorzugsweise zu wählen, wobei die oberste Schicht aus Kohlenstoff eine Schichtdicke von 500 nm aufweisen kann.

Innerhalb der Übergangsschicht 16 aus Cr sind in der rein schematischen Darstellung der Fig. 1 einige Punkte zu sehen, wobei die Dichte der Punkte im obersten Bereich der Schicht 16 in Fig. 1 höher ist als im unteren Bereich. Diese Punkte deuten auf WC-Moleküle hin, die gleichzeitig während der Ablagerung der Cr-Übergangsschicht abgelagert werden, wobei die Konzentration von WC in Cr in Richtung vom Substrat 12 bis zur Schicht 18 gehend kontinuierlich steigt und demzufolge die Konzentration von Cr in der Übergangsschicht in gleicher Richtung gehend kontinuierlich abnimmt. Auch eine stufenweise Zunahme der WC-Konzentration und Abnahme der Cr-Konzentration ist möglich. Die Cr-Schicht dient der Verankerung der Kohlenstoff-/Karbidschichtfolge auf dem Substrat 12.

Man merkt, daß die Linienführung der schematischen Zeichnung der Fig. 1 nicht streng geometrisch erfolgte, sondern daß jede Schichtgrenze kleinere Unregelmäßigkeiten aufweist, so daß auch die einzelnen Schichten leicht unterschiedliche Dicken aufweisen, je nachdem wo gemessen wird. Mikroskopisch betrachtet handelt es sich hier um sehr kleine Unregelmäßigkeiten, die sich aus den nachfolgend näher erläuterten Herstellungsverfahren ergeben, wobei die gezeigte leichte Unregelmäßigkeit der Oberfläche 14 des Substrats auf dessen Herstellung sowie des verwendeten Ätzverfahrens (Beschuß mit Ar+-Ionen) zurückzuführen ist.

Fig. 2 zeigt eine bevorzugte, zur Durchführung des erfindungsgemäßen Verfahrens verwendbare Beschichtungsanlage.

Diese Anlage ist strichliert im geschlossenen Zustand und mit ausgezogenen Linien mit geöffneten bzw. aufgesperrten Kammertüren dargestellt. Die hier gezeigte Anlage, die im Prinzip nach dem europäischen Patent 0 439 561 aufgebaut ist und betrieben wird, umfaßt 5 Targets 24, 26, 28, 30 und 32, wobei die Targets 24 und 26 in einer aufschwenkbaren Kammerwand 34 und die Targets 28 und 30 in der anderen aufschwenkbaren Kammerwand 36 gehalten sind.

Es handelt sich jeweils um Rechteck-Targets, die sich bezogen auf die Zeichnung vertikal erstrecken, und bevorzugt als unbalanzierte Magnetrons zur Durchführung eines Kathoden-Zerstäubungs-Verfahrens betrieben werden.

Dies gilt auch für das fünfte Target 32, das an einem Umfangsbereich des mittleren, feststehenden Teils der insgesamt im geschlossenen Zustand etwa quaderförmigen Kammer der Behandlungsvorrichtung aufgebracht ist.

Das Bezugszeichen 34 deutet auf eine Turbomolekularpumpe 6 hin, die zur Evakuierung der Behandlungskammer im geschlossen Zustand dient.

Das Bezugszeichen 36 zeigt in schematischer Form eine Zuführung für Schutzgas wie Argon, während die Zuführung 38 für ein Zusatzgas gedacht ist, zum Beispiel Wasserstoff oder ein Kohlenwasserstoff, der mit Vorteil in die erfindungsgemäße Beschichtung eingebaut werden kann.

Fig. 2 zeigt außerdem einen Substratträger 40, der einerseits um eine zentrale Achse 42 rotiert, und andererseits Substrathalter 44 aufweist, die wiederum um ihre Achse 46 rotieren, so daß durch den Vorbeilauf der Substrate bzw. Gegenstände vor den verschiedenen Targets die jeweils gewünschte Schichtbildung erfolgen kann.

In diesem Beispiel bestehen die Targets 28 und 24 aus Graphit und bilden somit eine Kohlenstoffquelle. Die Targets 30 und 26 bestehen aus WC und dienen der Erzeugung der oben erwähnten WC-Beschichtung 18.

Das Target 32 besteht aus Cr und dient der Erzeugung der Übergangsschicht 16.

Obwohl in diesem Beispiel die Targets 26 und 30 aus WC bestehen, können sie auch aus Karbiden anderer Elemente wie Ti, V, Cr, Zr, Nb, Mo, Hf und Ta oder aus SiC oder B₄C bestehen. Auch ist es möglich, die Targets 26 und 30 aus unterschiedlichen Karbiden auszubilden.

Nach der Anbringung der zu beschichtenden Substrate auf die Substrathalter 40 und das Schließen der Behandlungskammer wird zunächst evakuiert.

Während dieses Verfahrens oder kurz danach wird aufgeheizt, bis die Gegenstände 14 die gewünschte Betriebstemperatur erreicht haben. Man ist bemüht, unter Berücksichtigung des jeweils zu beschichtenden Materials, die höchstmögliche Temperatur anzuwenden, bei der die Eigenschaften des Materials keine Verschlechterung erfahren. Höhere Beschichtungstemperaturen fürhen zu kürzeren Beschichtungszeiten und zu dichteren Beschichtungen. Es gibt Forschungsergebnisse der Anmeldern, die vermuten lassen, daß eine optimale Beschichtung bei 200°C manchmal bei einer etwas niedrigeren Temperatur erreicht wird.

Es wird jetzt ein Ar-Ionen-Ätzverfahren durchgeführt mit einer Ionenenergie von üblicherweise 200 eV unter Anwendung eines der industriell verfügbaren Verfahren wie einer handelsüblichen linearen Plasmaquelle oder einer anderen linearen Ionenquelle oder einer Ar-Glimm-Entladung. Während dieses Behandlungsschrittes dreht sich der Substratträger 40 um die Achse 42. Die Substrathalter 44 drehen sich um die eigene Achse, wobei, falls gewünscht, die einzelnen Gegenstände 14 auch um ihre eigene Längsachse 48 gedreht werden können.

Auf diese Weise werden alle zu beschichtenden Oberflächen der Gegenstände 14, beispielsweise Plunger, Nockenstössel, Kipphebel usw. zumindest im wesentlichen gleichmäßig mit Argonionen geätzt und hierdurch gereinigt.

Nach Abschluß des Ätzverfahrens wird das Target 32 aus z.B. Cr weiter benutzt, um die Übergangsschicht 16 zu erzeugen. Während der Erzeugung dieser Übergangsschicht wird die Kathodenleistung am Cr-Target 32 allmählich heruntergefahren. Gleichzeitig wird die Kathodenleistung bei den WC-Targets 30 und 26 erhöht, um das Verhältnis der WC in der Übergangsschicht 16 allmählich zu erhöhen, während die Konzentration an Cr-Atomen allmählich herabgesetzt wird.

Nach Erzeugung der Schicht 16 nimmt das Target 32 nicht mehr am aktiven Verfahren teil. Es kann jedoch von Vorteil sein, das Target 32 mit niedriger Leistung weiter zu betreiben, um das Target sauber zu halten, falls das System nicht mit Schutzklappen versehen ist. Es wird nunmehr die in Fig. 1 angegebene Schichtfolge aus WC und C abgelagert, wobei hierzu die Graphittargets 28, 24 und die WC-Targets 26 und 30 gleichzeitig betrieben werden, und zwar wie oben erwähnt als jeweils unbalanziertes Magnetron.

Dadurch, daß die Substrate 14 auf den Substrathaltern 44 am Substratträger 40 abwechselnd durch den von den Targets 24 bis 30 kommenden Dampffluß hindurchpassieren, entsteht die erwünschte Schichtfolge 22. Die Drehung der Substrate 14 um die eigene Achse 48, um die Achse 46 der Substrathalter 44 und um die Achse des Substratträgers 40 führt zu einer aperiodischen Multischicht-Struktur, bei der die Dicke der einzelnen Schichten nicht einheitlich ist, sondern die Dicke der einzelnen Karbidschichten zwischen 1 und 3 nm, vorzugsweise bei etwa 2 nm liegt, während die Dicke der Kohlenstoffschicht zwischen 1 und 20 nm, vorzugsweise zwischen 2 und 4 nm liegt.

Das Verfahren wird solange durchgeführt, bis die erwünschte Gesamtschichtdicke der Beschichtung von etwa 1 µm erreicht wird bzw. bis die erwünschte Anzahl von Schichten entstanden ist.

Über die Zuführstützte 38 kann Wasserstoff oder ein Kohlenwasserstoff CₓH_{y}, vorzugsweise in Form von C₂H₂, der Kammeratmosphäre zugeführt werden, wodurch Wasserstoff in die Beschichtung aufgenommen wird, was der weiteren Herabsetzung der Reibungszahl dient.

Es wird üblicherweise eine relativ niedrige Zustrommenge von C₂H₂ der Kammeratmosphäre zugeführt, beispielsweise weniger als 20 % Volumenanteil der genannten Gaszufuhr und auf diese Weise wird bis zu 20 % Wasserstoff in die Beschichtung eingebaut. Diese hohe Einlagerung von Wasserstoff bei einem niedrigen Massen- bzw. Volumenstrom von C₂H₂ ist darauf zurückzuführen, daß der Kohlenstoff von den Graphit-Targets geliefert wird, während das Azetylen lediglich der Einbringung von Wasserstoff in die Beschichtung, nicht jedoch als Kohlenstoffquelle dient.

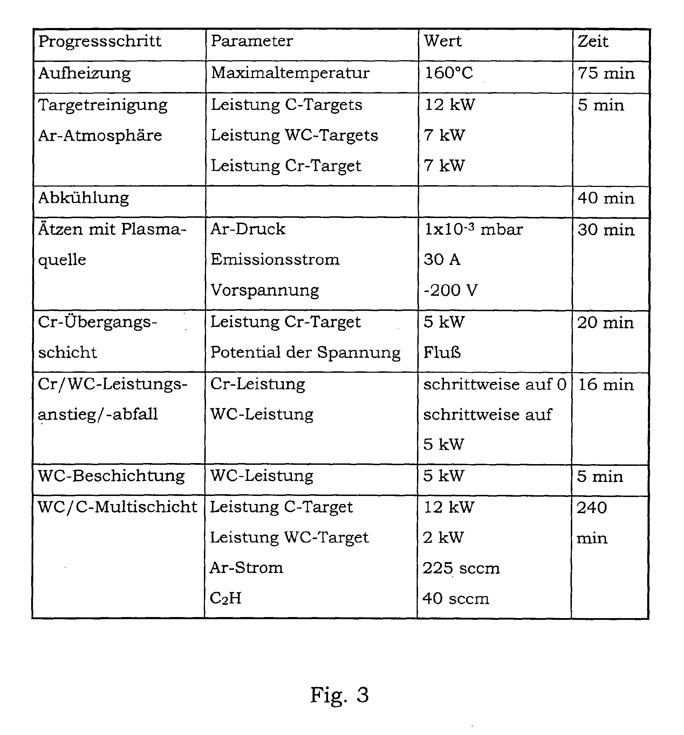

Die Betriebsparameter, die zur Erzeugung der Beschichtung vorzugsweise verwendet werden, sind in der Tabelle der Fig. 3 angegeben.

## Patentansprüche

1. Verfahren zur Herstellung von Beschichtungen mit niedriger Reibungszahl auf Gegenständen wie mechanischen Bauteilen und Werkzeugen, dadurch gekennzeichnet, daß man auf dem Gegenstand mittels eines PVD-Verfahrens eine Schichtfolge von abwechselnden Kohlenstoff- und Karbidschichten aufbaut, wobei die Karbidschichten aus einem Karbid mindestens eines Elements in Form eines Metalls und/oder Silizium und/oder Bor gebildet sind und der Kohlenstoff durch Zerstäubung eines Targets aus Graphit erzeugt wird, daß das Verfahren so durchgeführt wird, daß die Schichtdicke jeder Kohlenstoffschicht der Schichtfolge im Bereich zwischen etwa 1 nm und etwa 20 nm, vorzugsweise zwischen 2 und 4 nm liegt, wobei die oberste Schicht der Schichtfolge vorzugsweise aus Kohlenstoff besteht und mit Vorteil etwas dicker als die anderen Schichten sein darf, beispielsweise 500 nm, daß die Schichtdicke der Karbidschichten im Bereich zwischen 1 und 3 nm, vorzugsweise bei etwa 2 nm liegt und daß der Kohlenstoff der Kohlenstoffschicht vorwiegend sp3-Bindungen aufweist.

2. Verfahren nach Anspruch 1, dadurch gekennzeichnet, daß das Element aus der Gruppe W, Ti, V, Cr, Zr, Nb, Mo, Hf, Ta, B und Si ausgewählt wird.

3. Verfahren nach Anspruch 1 oder 2, dadurch gekennzeichnet, daß das Verhältnis der Anzahl sp3 - Bindungen zu sp2-Bindungen, gemessen mit üblichen Meßmethoden wie Raman-Spektroskopie, größer als 1 ist.

4. Verfahren nach einem der vorhergehenden Ansprüche, dadurch gekennzeichnet, daß das Verfahren so durchgeführt wird, daß die Gesamtdicke der Schichtfolge im Bereich zwischen etwa 0,1 µm und etwa 20µm, vorzugsweise zwischen 1 µm und 5 µm und insbesondere zwischen 2 und 5 µm liegt.

5. Verfahren nach einem der vorhergehenden Ansprüche, dadurch gekennzeichnet, daß das benutzte PVD-Verfahren als nicht reaktives Kathoden-Zerstäubungs-Verfahren durchgeführt wird, insbesondere unter Anwendung mehrerer unbalanzierten Magnetronen.

6. Verfahren nach einem der vorhergehenden Ansprüche, dadurch gekennzeichnet, daß Wasserstoff oder ein Kohlenwasserstoff CₓH_{y} (x und y sind Integerzahlen), vorzugsweise in Form von C₂H₂, in die nicht reaktive Atmosphäre des PVD-Verfahrens eingeführt wird, um Wasserstoff in die Beschichtung einzubauen.

7. Verfahren nach einem der vorhergehenden Ansprüche, dadurch gekennzeichnet, daß vor der Ablagerung der Kohlenstoff- und Karbidschichten die Oberfläche des Gegenstandes mittels Ionenätzen gereinigt wird, vorzugsweise unter Anwendung von Argonionen.

8. Verfahren nach einem der vorhergehenden Ansprüche, dadurch gekennzeichnet, daß vor Ablagerung der Kohlenstoff- und Karbidschichten eine Cr-Schicht oder Ti-Schicht zur Adhäsionsvermittlung auf die Oberfläche des Gegenstandes, ggf. nach dem Ionenätzen, abgelagert wird.

9. Verfahren nach Anspruch 8, dadurch gekennzeichnet, daß die Cr-Schicht eine Dicke im Bereich von etwa 1 nm bis etwa 2 µm aufweist, vorzugsweise 0,1 µm bis 0,5 µm.

10. Verfahren nach Anspruch 8 oder 9, dadurch gekennzeichnet, daß bei der Ablagerung der Cr-Schicht die Kathodenleistung des Cr-Targets verkleinert wird und bei der Ablagerung der gewählten Karbidschicht die Kathodenleistung des entsprechenden Targets gleichzeitig erhöht wird, um eine Übergangsschicht mit abfallender Cr-Konzentration und steigender Karbidkonzentration zu erzeugen.

11. Verfahren nach einem der vorhergehenden Ansprüche, dadurch gekennzeichnet, daß die Behandlungskammer mindestens ein erstes Target aus Kohlenstoff, vorzugsweise in Form von Graphit, und vorzugsweise ein zweites Target aus einem Metallkarbid oder SiC oder B₄C aufweist und daß die zu beschichtenden Gegenstände in der Behandlungskammer gedreht werden, um die erwünschte Schichtfolge in Form einer aperiodischen Mehrschichtstruktur zu erhalten.

12. Verfahren nach Anspruch 11, dadurch gekennzeichnet, daß die Drehung der Gegenstände in an sich bekannter Weise um eine, zwei, drei oder mehr Achsen erfolgt.

13. Verfahren nach einem der vorhergehenden Ansprüche, dadurch gekennzeichnet, daß es unter Anwendung einer Beschichtungsvorrichtung entsprechend der europäischen Patentanmeldung 99 909 697 erfolgt.

14. Verfahren nach einem der vorhergehenden Ansprüche, dadurch gekennzeichnet, daß folgende Betriebsparameter verwendet werden, um die Kohlenstoffschichten zu erzeugen:
- Leistung am Kohlenstofftarget 12kW,
- Ar-Zuführ 225sccm,
- C₂H₂-Zuführ 40 sccm.

15. Verfahren nach einem der vorhergehenden Ansprüche, dadurch gekennzeichnet, daß folgende Betriebsparameter verwendet werden, um die Karbidschichten zu erzeugen:
- Leistung am WC-Target 2kW,
- Ar-Zuführ 225sccm,
- C₂H₂-Zuführ 40 sccm.

16. Gegenstand, insbesondere nach einem Verfahren gemäß einem der vorhergehenden Ansprüche hergestellt, mit einer abwechselnden Schichtfolge von Kohlenstoff- und Karbidschichten auf mindestens einem Oberflächenbereich, wobei die Schichtdicke jeder Kohlenstoff-schicht der Schichtfolge im Bereich zwischen etwa 1 nm und etwa 20 nm, vorzugsweise zwischen 2 und 4 nm liegt, wobei die oberste Schicht der Schichtfolge vorzugsweise aus Kohlenstoff besteht und mit Vorteil etwas dicker als die anderen Schichten sein darf, beispielsweise 500 nm, daß die Schichtdicke der Karbidschichten im Bereich zwischen 1 und 3 nm, vorzugsweise bei etwa 2 nm liegt und daß der Kohlenstoff der Kohlenstoffschicht vorwiegend sp₃-Bindungen aufweist.

17. Gegenstand nach Anspruch 16, dadurch gekennzeichnet, daß das Karbid ein Karbid eines oder mehrerer der nachfolgenden Elemente ist: W, Ti, V, Cr, Zr, Nb, Mo, Hf, Ta, B und Si.

18. Gegenstand nach einem der vorhergehenden Ansprüche 16 oder 17, dadurch gekennzeichnet, daß das Verfahren so durchgeführt wird, daß die Gesamtdicke der Schichtfolge im Bereich zwischen etwa 0,1 und 20µm, vorzugsweise zwischen 1 µm und 5 µm und vorzugsweise zwischen 2 µm und 3 µm liegt.

19. Gegenstand nach einem der vorhergehenden Ansprüche 16 bis 18, dadurch gekennzeichnet, daß Wasserstoff in der Beschichtung enthalten ist.

20. Gegenstand nach einem der vorhergehenden Ansprüche 16 bis 19, dadurch gekennzeichnet, daß sich eine Cr-Schicht oder Ti-Schicht zur Adhäsionsvermittlung auf der Oberfläche des Gegenstandes unterhalb der abwechselnden Schichtfolge befindet.

21. Gegenstand nach Anspruch 20, dadurch gekennzeichnet, daß die Cr-Schicht eine Dicke im Bereich von etwa 1 nm bis etwa 2 µm, vorzugsweise 0,1 bis 0,5 µm aufweist.

22. Gegenstand nach Anspruch 20 oder 21, dadurch gekennzeichnet, daß die Übergangsschicht in Richtung der freien Oberfläche gehend eine abfallende Cr-Konzentration und eine steigende Karbidkonzentration aufweist.

23. Gegenstand nach einem der vorhergehenden Ansprüche 16 bis 22, dadurch gekennzeichnet, daß die Schichtfolge die Form einer aperiodischen Mehrschichtstruktur aufweist.
